# EUROPÄISCHE PATENTSCHRIFT

(11) **EP 3 645 980 B1**
(45) Veröffentlichungstag und Bekanntmachung des Hinweises auf die Patenterteilung: **09.08.2023**
(21) Anmeldenummer: 18733790.2
(22) Anmeldetag: 07.06.2018
(51) Int. Cl.: G01D 5/244, G01D 18/00

(54) **VERFAHREN UND VORRICHTUNG ZUR JUSTIERUNG EINER POSITION EINES MAGNETEN ZU EINEM GMR-SENSOR**
METHOD AND DEVICE FOR ADJUSTING THE POSITION OF A MAGNET RELATIVE TO A GMR SENSOR
PROCÉDÉ ET DISPOSITIF D'AJUSTEMENT DE LA POSITION D'UN AIMANT PAR RAPPORT À UN CAPTEUR GMR

(30) Priorität: 29.06.2017 DE 102017114511
(43) Veröffentlichungstag der Anmeldung: 06.05.2020
(73) Patentinhaber: Schaeffler Technologies AG & Co. KG, 91074 Herzogenaurach (DE)
(72) Erfinder: DIETRICH, Markus, 77704 Oberkirch (DE)
(86) Internationale Anmeldenummer: PCT/DE2018/100545
(87) Internationale Veröffentlichungsnummer: WO 2019/001629

(56) Entgegenhaltungen:
- JP-A- 2012 114 997
- JP-A- 2012 114 997
- JP-A- 2016 138 815
- JP-A- 2016 138 815

## Beschreibung

Die Erfindung betrifft ein Verfahren zur Justierung einer Position eines Magneten zu einem GMR-Sensor, mit welchem aus einem sich veränderlichen Magnetfeld, das von dem an einem Rotor einer Antriebseinheit befestigten Magneten erzeugt wird, auf eine Position des Rotors durch eine Auswerteeinheit geschlossen wird.

In modernen Kraftfahrzeugen, insbesondere Personenkraftwagen, werden zunehmend automatisierte Kupplungen eingesetzt. Die dabei verwendeten Kupplungen sind in hydraulischen Kupplungssystemen eingesetzt, bei welchen ein elektro-hydraulischer Aktor, der von einem rein elektrisch kommutierten Elektromotor angetrieben wird, über eine Hydraulikleitung mit der Kupplung verbunden ist. Zur korrekten Kommutierung weist der Elektromotor einen Sensor auf, welcher die Position des Elektromotors während des Betriebes des Aktors detektiert. Zu diesem Zweck müssen Multiturn-Sensoren verwendet werden, da es notwendig ist, dass mehr als eine Umdrehung des Elektromotors für eine Feststellung eines Verfahrweges des Aktors notwendig ist. Zu diesen Multiturn-Sensoren gehören auch GMR-Sensoren. Beim Einsatz solcher GMR- Sensoren muss der Magnetkreis des Elektromotors so ausgelegt sein, dass sich das Magnetfeld immer in dem für den Sensor spezifizierten Arbeitsbereich befindet. Dies kann aber am GMR-Sensor selber nicht festgestellt werden. Der optimale Arbeitsbereich eines GMR-Sensors ist sehr eng bemessen. Ist das Magnetfeld zu schwach, werden die Polübergänge des Magneten nicht weiter gedreht und somit verzählt sich der Sensor. Das heißt, eine Umdrehung wird nicht gezählt, obwohl der Magnet sich bewegt. Im entgegengesetzten Fall, wenn das Magnetfeld zu stark ist, werden Polübergänge generiert, obwohl sich der Magnet nicht dreht.

Das Dokument JP 2016 138815 A beschreibt ein Verfahren zur Justierung einer axialen Position eines Magneten eines Winkelsensors in Bezug zu einem ortsfesten MR-Sensor.

Das Dokument JP 2012 114997 A beschreibt einen Winkelsensor mit einem auf einem Rotor angeordneten Magneten, dessen Magnetfeld von einem ortsfesten MR-Sensor sowie von zwei Hall-Elementen erfasst wird.

Der Erfindung liegt die Aufgabe zugrunde, ein Verfahren zur Justierung einer Position eines Magneten zu einem GMR-Sensor anzugeben, bei welchem der optimale Arbeitsbereich des GMR-Sensors eingestellt wird.

Diese Aufgabe wird durch ein Verfahren gemäß Anspruch 1 gelöst.

Im Einklang mit der Erfindung wird ein optimaler Arbeitsbereich des GMR-Sensors aus einer Richtung und/oder Drehung eines magnetischen Summenvektors des von dem Magneten aufgespannten Magnetfeldes abgeleitet, indem eine magnetische Feldstärke in einer von dem Summenvektor aufgespannten Ebene mit einem zweiten Magnetfeldsensor gemessen wird. Durch die Messung der magnetischen Feldstärke durch den zweiten Magnetfeldsensor lässt sich einfach feststellen, ob sich der Magnet in einem für den GMR-Sensor optimalen Arbeitsbereich befindet.

Vorteilhafterweise wird als zweiter Magnetfeldsensor ein Hall-Effekt-Sensor verwendet, dessen Erfassungsbereich senkrecht zur Drehachse des Rotors ausgerichtet ist. Dadurch wird gewährleistet, dass auch tatsächlich in der von dem magnetischen Summenvektor aufgespannten Ebene die Feldstärke zuverlässig bestimmt wird.

In einer Ausgestaltung wird bei der Feldstärkemessung durch den zweiten Magnetfeldsensor der Magnet am Rotor so verstellt, bis der optimale Arbeitsbereich der magnetischen Feldstärke des GMR-Sensors durch den zweiten Magnetfeldsensor ermittelt wird. Dabei lässt sich die zu messende physikalische Größe in Form der Flussdichte einfach einstellen und man kann auf eine Bestimmung eines geometrischen Abstands zwischen Magnet und GMR-Sensor, der nur näherungsweise dem Magnetfeld entspricht, verzichten. Somit müssen Feldstärketoleranzen der Magneten nicht berücksichtigt werden.

In einer Ausführungsform wird die Justierung des Magneten zum GMR-Sensor am Bandende der Herstellung des Antriebselementes durchgeführt. Durch diese einmalige Messung am Bandende wird der Magnet zuverlässig gegenüber dem GMR-Sensor positioniert, so dass der GMR-Sensor immer im optimalen Arbeitsbereich arbeitet.

Eine Weiterbildung der Erfindung betrifft eine Vorrichtung zur Justierung einer Position eines Magneten zu einem GMR-Sensor gemäß Anspruch 4.

Bei einer Vorrichtung, bei welcher sichergestellt wird, dass das vom Magneten aufgespannte Magnetfeld immer im spezifizierten Arbeitsbereich des GMR-Sensors liegt, ist ein vertikaler Hall-Effekt-Sensor zur Erfassung einer Feldstärke des durch den Magneten generierten veränderlichen Magnetfeldes Bestandteil der Auswerteschaltung. Da dieser Hall-Effekt-Sensor gemeinsam mit der Auswerteschaltung in einem Herstellungsprozess hergestellt wird, ist die Integration des Hall-Effekt-Sensor nahezu kostenneutral, da dieser in den gleichen Prozessen wie der restliche Teil der als ASIC ausgebildeten Auswerteschaltung hergestellt werden kann. Durch die Verwendung eines vertikalen Hall-Effekt-Sensors wird sichergestellt, dass dieser auch wirklich in derselben Ebene aktiv ist wie der GMR-Sensor und somit die gleiche Feldstärkeänderung detektiert.

Vorteilhafterweise ist der vertikale Hall-Effekt-Sensor innerhalb der Halbleiterschichten der Auswerteschaltung ausgebildet. Ein Anbringen eines separaten Hall-Effekt-Sensors kann dabei entfallen.

In einer Ausgestaltung ist der Erfassungsbereich des vertikalen Hall-Effekt-Sensors auf eine Ebene ausgerichtet, in welcher ein magnetischer Summenvektor des Magnetfeldes sich bewegt. Damit misst der Hall-Effekt-Sensor immer genau in derselben Ebene wie auch der GMR-Sensor, wodurch gewährleistet ist, dass auch die auftretende magnetischen Feldstärke zuverlässig bestimmt wird.

In einer Ausführungsform ist der GMR-Sensor als Multiturn-Sensor ausgebildet. Dies hat den Vorteil, dass auch bei mehreren Umdrehungen des Rotors des Elektromotors dessen Position zum Verfahren eines Aktors sicher festgestellt werden kann.

Die Erfindung lässt zahlreiche Ausführungsformen zu. Eine davon soll anhand der in der Zeichnung dargestellten Figuren näher erläutert werden.

Es zeigen:
- Fig. 1: eine vereinfachte Darstellung eines Kupplungsbetätigungssystems zur Betätigung einer automatisierten Reibungskupplung,
- Fig. 2: Prinzipdarstellung einer rotierenden Komponente des Elektromotors,
- Fig. 3: einen Ausschnitt aus einem Rotor eines Elektromotors mit einem Magnetgeberring,
- Fig. 4: eine Prinzipdarstellung eines GMR-Sensors.

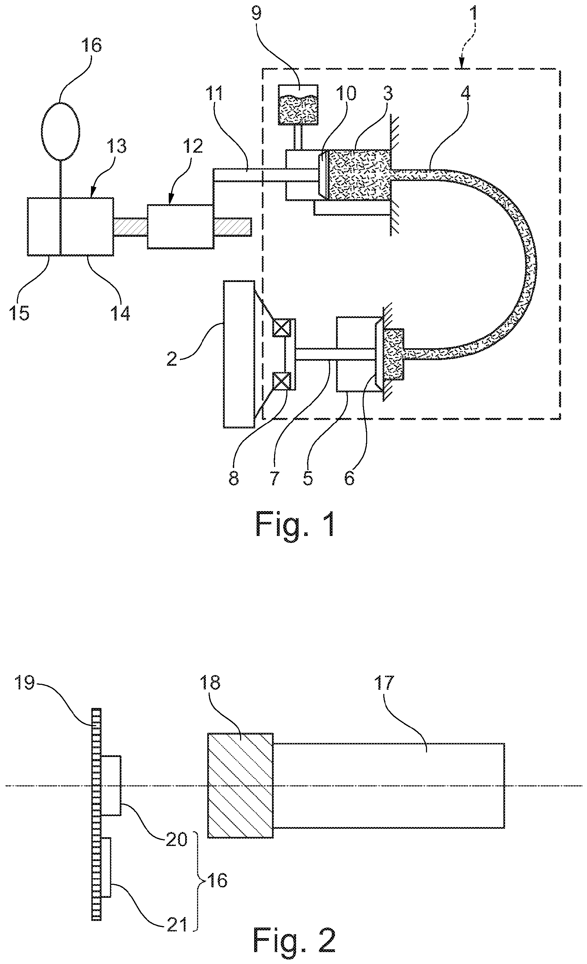

In Fig. 1 ist ein Kupplungsbetätigungssystem 1 für eine automatisierte Kupplung vereinfacht dargestellt. Das Kupplungsbetätigungssystem 1 ist in einem Antriebsstrang eines Kraftfahrzeuges einer Reibungskupplung 2 zugeordnet und umfasst einen Geberzylinder 3, der über eine auch als Druckleitung bezeichnete Hydraulikleitung 4 mit einem Nehmerzylinder 5 verbunden ist. In dem Nehmerzylinder 5 ist ein Nehmerkolben 6 hin und her bewegbar, der über ein Betätigungsorgan 7 und unter Zwischenschaltung eines Lagers 8 die Reibungskupplung 2 betätigt. Der Geberzylinder 3 ist über eine Verbindungsöffnung mit einem Ausgleichsbehälter 9 verbindbar. In dem Geberzylinder 3 ist ein Geberkolben 10 axial bewegbar gelagert. Von dem Geberkolben 10 geht eine Kolbenstange 11 aus, die in Längserstreckung des Geberzylinders 3 zusammen mit dem Geberkolben 10 translatorisch bewegbar ist. Die Kolbenstange 11 des Geberzylinders 3 ist über eine Gewindespindel 12 mit einem elektromotorischen Stellantrieb 13 gekoppelt. Der elektromotorische Stellantrieb 13 umfasst einen als kommutierten Gleichstrommotor ausgebildeten Elektromotor 14 und eine Auswerteschaltung 15. Die Gewindespindel 12 setzt eine Drehbewegung des Elektromotors 14 in eine Längsbewegung der Kolbenstange 11 und somit des Geberkolbens 10 um. Die Reibungskupplung 2 wird somit durch den Elektromotor 14, die Gewindespindel 12, den Geberzylinder 3 und den Nehmerzylinder 5 automatisiert betätigt. In dem elektromotorischen Stellantrieb 13 ist eine Sensorik 16 integriert.

Eine Prinzipdarstellung einer rotierenden Komponente des Elektromotors 14 mit der Sensorik 16 ist in Fig. 2 dargestellt. Der elektromotorische Stellantrieb 13 weist dabei einen Rotor 17 auf, wobei als Rotor 17 eine Welle des Elektromotors 14 betrachtet wird. Mittels der Sensorik 16 wird eine Winkelposition des Rotors 17 des Elektromotors 14 zur genauen Einstellung der Position der Kupplung 2 bestimmt. Der Rotor 17 besitzt an einer Frontseite einen Magneten 18, während auf einer dem Magneten 18 gegenüberliegenden Platine 19 die Sensorik 16 befestigt ist. Die Sensorik 16 umfasst einen GMR-Sensor 20 und eine Auswerteschaltung 21 des GMR-Sensors. GMR-Sensoren arbeiten auf Grundlage eines Effektes, bei welchem die Magnetfeldmessung auf dem Riesenmagnetowiderstand basiert. Dieser Effekt bewirkt, dass der elektrische Widerstand von Strukturen von der gegenseitigen Orientierung der Magnetisierung der magnetischen Schichten abhängt. Dieser Effekt ist bei der Magnetisierung in entgegengesetzten Richtungen deutlich höher als bei der Magnetisierung in die gleiche Richtung.

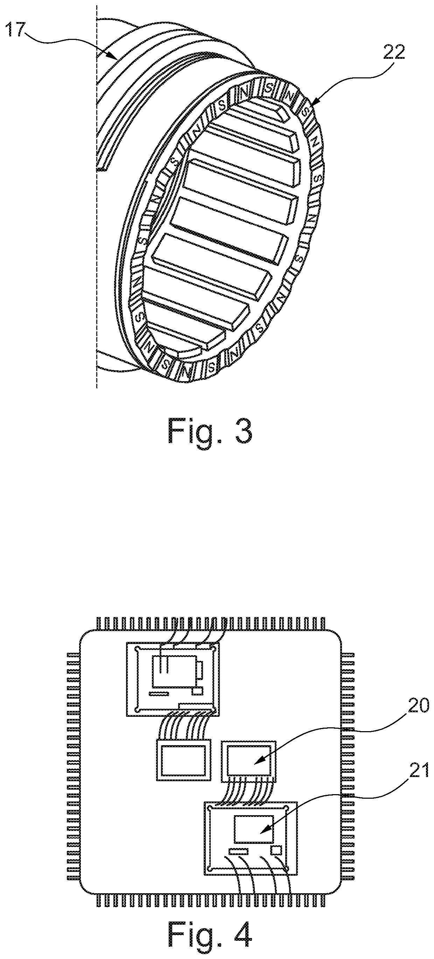

Fig. 3 zeigt einen Ausschnitt aus dem Rotor 17 des Elektromotors 14, welcher an seinem Umfang einen Magneten 18 aufweist, der als Magnetgeberring 22 ausgebildet ist. Der Magnetgeberring 22 stellt dabei einen Maßkörper dar und umfasst eine vorgegebene Anzahl von Magnetpolen N bzw. S, die über 360° verteilt aneinandergereiht sind. Der Magnetgeberring 22 ist drehfest mit dem Rotor 17 verbunden, während die Sensorik 16, die das von dem Magnetgeberring 22 aufgebaute Magnetfeld detektiert, entweder gegenüberliegend zum Magnetgeberring 22 angeordnet ist, oder aber an einem nicht weiter dargestellten Stator des Elektromotors 14 befestigt ist.

Wie aus Fig. 4 hervorgeht, wo eine Draufsicht auf die Sensorik 16 dargestellt ist, besteht die Sensorik 16 prinzipbedingt aus zwei Komponenten: einmal der als GMR-Sensor 20 dienenden spiralförmigen GMR-Brücke und der als ASIC ausgebildeten Auswerteschaltung 21, in der auch eine Signalkonditionierung des von dem GMR-Sensor 20 abgegebenen Signals vorgenommen wird. Da sich diese beiden Bauelemente 20, 21 auf einer Leiterplatte 19 in einem Gehäuse befinden, ist die Toleranz zwischen den beiden Bauelemente 20, 21 sehr gering. Das bedeutet, dass diese im Betrieb annähernd das gleiche Magnetfeld oder Magnetfelder mit einem konstanten Delta erfassen, welches bei der Bestimmung der Position des Elektromotors 14 herausgerechnet werden kann.

In der Halbleiter-Topologie der Auswerteschaltung 21 ist zusätzlich ein nicht weiter gezeigter vertikaler Hall-Effekt-Sensor integriert. Mit diesem Hall-Effekt-Sensor, wie er beispielsweise als Vertikal-Hall-Effekt-Sensor der Firmen Allegro, Micronas und Frauenhofer bzw. als 3D-Hall der Firma Melexis angeboten wird, wird kontinuierlich die magnetische Feldstärke gemessen, die von dem sich mit dem Rotor 17 drehenden Magnetgeberring 22 erstellt wird. Ein solcher vertikaler Hall-Sensor weist einen Erfassungsbereich auf, der mit dem Erfassungsbereich des GMR-Sensors identisch ist und die Ebene ausmisst, in welcher sich eine Richtung bzw. die Drehung eines magnetischen Summenvektors des Magnetfeldes ändert.

Um nun den Magnetgeberring 22 zuverlässig gegenüber dem GMR-Sensor 20 zu montieren, wird durch den Hall-Effekt-Sensor in einem Bandende-Prozess zur Herstellung des Kupplungsbetätigungssystems der Magnetgeberring 22 bewegt, wobei die sich ändernde magnetische Feldstärke kontinuierlich durch den Hall-Effekt-Sensor gemessen wird. Dabei wird die von dem Hall-Effekt-Sensor gemessene magnetische Feldstärke mit den für den jeweiligen GMR-Sensor 20 spezifizierten magnetischen Feldstärken verglichen. Die für GMR-Sensor 20 spezifizierten magnetischen Feldstärken können beispielsweise in einem Bereich zwischen 15 mT bis 35 mT oder in einem Bereich zwischen 20 mT und 40 mT liegen. Hat der Magnetgeberring 22 eine Position erreicht, wo die angezeigte Feldstärke des Hall-Effekt-Sensors innerhalb dieser spezifizierten Bereiche des GMR-Sensors 20 liegt, wird davon ausgegangen, dass der GMR-Sensor 20 in dem ihm eigenen spezifischen Arbeitsbereich betrieben werden kann.

Aufgrund dieser Lösung kann bei der Montage von Magnetgeberring 22 und GMR-Sensor 20 auf eine Berücksichtigung baulicher und geometrischer Toleranzen der Magneten verzichtet werden, da der Hall-Effekt-Sensor genau angibt, wenn sich der GMR-Sensor 20 in seinem optimalen Betriebspunkt befindet.

### Bezugszeichenliste

- 1: Kupplungsbetätigungssystem
- 2: Reibungskupplung
- 3: Geberzylinder
- 4: Hydraulikleitung
- 5: Nehmerzylinder
- 6: Nehmerkolben
- 7: Betätigungsorgan
- 8: Lager
- 9: Ausgleichsbehälter
- 10: Geberkolben
- 11: Kolbenstange
- 12: Gewindespindel
- 13: Stellantrieb
- 14: Elektromotor
- 15: Auswerteschaltung
- 16: Sensorik
- 17: Rotor
- 18: Magnet
- 19: Platine
- 20: GMR-Sensor
- 21: Auswerteschaltung
- 22: Magnetgeberring

## Patentansprüche

1. Verfahren zur Justierung einer Position eines Magneten (18) eines Winkelsensors zu einem ortsfesten GMR-Sensor (20), umfassend den an einem drehbaren Rotor (17) einer Antriebseinheit (14) angeordneten Magneten (18), der mit dem GMR-Sensor (20) in einer Wirkverbindung steht, wobei der GMR-Sensor (20) gemeinsam mit einer Auswerteschaltung (21) auf einer Trägerplatte (19) ausgebildet ist, wobei ein zweiter Magnetfeldsensor, zur Erfassung einer Feldstärke eines durch den Magneten (18) generierten veränderlichen Magnetfeldes Bestandteil der Auswerteschaltung (21) ist, wobei mit dem GMR-Sensor aus dem veränderlichen Magnetfeld, das von dem an dem Rotor (17) der Antriebseinheit (14) befestigten Magneten (18) erzeugt wird, auf eine Position des Rotors (17) durch die Auswerteschaltung (21) geschlossen wird, **dadurch gekennzeichnet, dass** zur Justierung der Position des an dem Rotor (17) befestigten Magneten (18) gegenüber dem zugehörigen GMR-Sensor (20) der Magnet (18) relativ zum Rotor (17) bewegt wird und gleichzeitig die sich ändernde magnetische Feldstärke kontinuierlich mit dem zweiten Magnetfeldsensor, welcher in einem geringen Abstand zum GMR-Sensor (20) angebracht ist, gemessen wird, wobei die von dem zweiten Magnetfeldsensor kontinuierlich gemessene magnetische Feldstärke mit einem für den GMR-Sensor (20) spezifizierten magnetischen Feldstärkebereich verglichen wird und festgestellt wird, dass sich der Magnet (18) in einem optimalen Arbeitsbereich befindet, wenn er eine Position erreicht hat, an der die kontinuierlich gemessene Feldstärke des zweiten Magnetfeldsensors innerhalb des spezifizierten Feldstärkebereichs des GMR-Sensors (20) bleibt.

2. Verfahren nach Anspruch 1, **dadurch gekennzeichnet, dass** als zweiter Magnetfeldsensor ein Hall-Effekt-Sensor verwendet wird, dessen Erfassungsbereich senkrecht zur Drehachse des Rotors (17) ausgerichtet ist.

3. Verfahren nach mindestens einem der vorhergehenden Ansprüche, **dadurch gekennzeichnet, dass** die Justierung des Magneten (18) zum GMR-Sensor (20) am Bandende der Herstellung des Antriebselementes (14) durchgeführt wird.

4. Vorrichtung zur Justierung einer Position eines Magneten zu einem GMR-Sensor, umfassend einen GMR-Sensor (20), eine Auswerteschaltung (21), eine Trägerplatte (19) und einen an einem Rotor (17) einer Antriebseinheit (14) 2. anordenbaren Magneten (18), der mit dem GMR-Sensor (20) in einer Wirkverbindung steht, wobei der GMR-Sensor (20) gemeinsam mit der Auswerteschaltung (21) auf der Trägerplatte (19) ausgebildet ist, wobei ein vertikaler Hall-Effekt-Sensor, der in einem geringen Abstand zum GMR-Sensor (20) angebracht ist, zur Erfassung einer Feldstärke des durch den Magneten (18) generierten, veränderlichen Magnetfeldes Bestandteil der Auswerteschaltung (21) ist, **dadurch gekennzeichnet, dass** die Vorrichtung dazu eingerichtet ist, eine vom zweiten Magnetfeldsensor kontinuierlich gemessene magnetische Feldstärke mit einem für den GMR-Sensor (20) spezifizierten magnetischen Feldstärkebereich zu vergleichen und festzustellen, dass sich der Magnet (18) in einem optimalen Arbeitsbereich befindet, wenn die kontinuierlich gemessene Feldstärke des zweiten Magnetfeldsensors innerhalb des spezifizierten Feldstärkebereichs des GMR-Sensors (20) bleibt.

5. Vorrichtung nach Anspruch 4, **dadurch gekennzeichnet, dass** der vertikale Hall-Effekt-Sensor innerhalb der Halbleiterschichten der Auswerteschaltung (21) ausgebildet ist.

## Claims

1. A method for adjusting the position of a magnet (18) of an angle sensor relative to a stationary GMR sensor (20), comprising the magnet (18) arranged on a rotatable rotor (17) of a drive unit (14), which magnet is operatively connected to the GMR sensor (20), wherein the GMR sensor (20) is formed together with an analysis circuit (21) on a carrier plate (19), wherein a second magnetic field sensor for detecting a field strength of a variable magnetic field generated by the magnet (18) is a component of the analysis circuit (21), wherein the GMR sensor is used to infer a position of the rotor (17) by means of the analysis circuit (21) from the variable magnetic field generated by the magnet (18) attached to the rotor (17) of the drive unit (14), **characterised in that** in order to adjust the position of the magnet (18) attached to the rotor (17) relative to the associated GMR sensor (20), the magnet (18) is moved relative to the rotor (17) and, at the same time, the changing magnetic field strength is continuously measured with the second magnetic field sensor, which is mounted at a small distance from the GMR sensor (20), wherein the magnetic field strength continuously measured by the second magnetic field sensor is compared with a magnetic field strength range specified for the GMR sensor (20) and it is determined that the magnet (18) is in an optimum operating range when it has reached a position at which the continuously measured field strength of the second magnetic field sensor remains within the specified field strength range of the GMR sensor (20).

2. The method according to claim 1, **characterised in that** a Hall effect sensor is used as the second magnetic field sensor, the detection range of which is aligned perpendicular to the axis of rotation of the rotor (17).

3. The method according to at least one of the preceding claims, **characterised in that** the adjustment of the magnet (18) to the GMR sensor (20) is carried out at the end-of-line of the manufacture of the drive element (14).

4. A device for adjusting the position of a magnet relative to a GMR sensor, comprising a GMR sensor (20), an analysis circuit (21), a carrier plate (19) and a magnet (18) that can be arranged on a rotor (17) of a drive unit (14) and is operatively connected to the GMR sensor (20), wherein the GMR sensor (20) is formed together with the analysis circuit (21) on the carrier plate (19), wherein a vertical Hall effect sensor, which is mounted at a small distance from the GMR sensor (20), for detecting a field strength of the variable magnetic field generated by the magnet (18) is a component of the analysis circuit (21), **characterised in that** the device is designed to compare a magnetic field strength continuously measured by the second magnetic field sensor with a magnetic field strength range specified for the GMR sensor (20) and to determine that the magnet (18) is in an optimum operating range when the continuously measured field strength of the second magnetic field sensor remains within the specified field strength range of the GMR sensor (20).

5. The device according to claim 4, **characterised in that** the vertical Hall effect sensor is formed within the semiconductor layers of the analysis circuit (21).

## Revendications

1. Procédé d'ajustement de la position d'un aimant (18) d'un capteur d'angle par rapport à un capteur GMR fixe (20), comprenant l'aimant (18) juxtaposé à un rotor mobile (17) d'une unité d'entraînement (14), et qui est en liaison active avec le capteur GMR (20), le capteur GMR (20), conjointement avec un circuit d'analyse (21), étant formé sur une plaque de support (19), un second capteur de champ magnétique, permettant de mesurer une intensité d'un champ magnétique variable généré par l'aimant (18), faisant partie d'un élément du circuit d'analyse (21), la position du rotor (17) pouvant être déterminée à l'aide du capteur GMR, par le biais du circuit d'analyse (21), à partir du champ magnétique variable produit par l'aimant (18) fixé au rotor (17) de l'unité d'entraînement (14), **caractérisé en ce que**, pour ajuster la position de l'aimant (18) fixé au rotor (17), l'aimant (18) se déplace par rapport au rotor (17) en faisant face au capteur GMR (20) correspondant, et l'intensité variable du champ magnétique est mesurée simultanément en continu à l'aide du second capteur de champ magnétique qui est monté à courte distance du capteur GMR (20), l'intensité du champ magnétique mesurée en continu par le second capteur de champ magnétique étant comparée à une plage d'intensité du champ magnétique spécifiée pour le capteur GMR (20), et étant déterminé que l'aimant (18) se trouve dans une plage de fonctionnement optimale lorsqu'il atteint une position pour laquelle l'intensité du champ mesurée en continu par le second capteur de champ magnétique reste dans le plage d'intensité du champ spécifié pour le capteur GMR (20).

2. Procédé selon la revendication 1, **caractérisé en ce qu'**un capteur à effet Hall est utilisé comme second capteur de champ magnétique, dont la zone de détection est orientée perpendiculairement à l'axe de rotation du rotor (17).

3. Procédé selon au moins l'une quelconque des revendications précédentes, **caractérisé en ce que** l'ajustement de l'aimant (18) par rapport au capteur GMR (20) est réalisé à l'issue de la fabrication de l'unité d'entraînement (14).

4. Dispositif d'ajustement d'une d'un aimant par rapport à un capteur GMR, comprenant un capteur GMR (20), un circuit d'analyse (21), une plaque de support (19) et un aimant (18) fixé au rotor (17) d'une unité d'entraînement (14), lequel est en liaison active avec le capteur GMR (20), le capteur GMR (20), conjointement avec le circuit d'analyse (21), étant formé sur la plaque de support (19), un capteur à effet Hall vertical, qui est monté à courte distance du capteur GMR (20), faisant partie du circuit d'analyse (21) pour détecter l'intensité du champ magnétique variable généré par l'aimant (18), **caractérisé en ce que** le dispositif est adapté pour comparer une intensité de champ magnétique mesurée en continu par le second capteur de champ magnétique à une plage d'intensité du champ magnétique spécifiée pour le capteur GMR (20), et pour déterminer que l'aimant (18) se situe dans une plage de fonctionnement optimale lorsque l'intensité du champ mesurée en continu par le second capteur de champ magnétique reste dans la plage d'intensité du champ spécifiée du capteur GMR (20).

5. Dispositif selon la revendication 4, **caractérisé en ce que** le capteur à effet Hall vertical est formé à l'intérieur de la couche semi-conductrice du circuit d'analyse (21).
